# EUROPÄISCHE PATENTSCHRIFT

(11) **EP 1 218 573 B1**
(45) Veröffentlichungstag und Bekanntmachung des Hinweises auf die Patenterteilung: **09.03.2005**
(21) Anmeldenummer: 00965787.5
(22) Anmeldetag: 24.08.2000
(51) Int. Cl.: C30B 25/02, C30B 29/36, C30B 25/12, C30B 25/10, C30B 25/14

(54) **VERFAHREN UND VORRICHTUNG ZUR ABSCHEIDUNG VON MATERIALIEN MIT GROSSER ELEKTRONISCHER BANDLÜCKE UND GROSSER BINDUNGSENERGIE**
METHOD AND DEVICE FOR DEPOSITING MATERIALS WITH A LARGE ELECTRONIC ENERGY GAP AND HIGH BINDING ENERGY
PROCEDE ET DISPOSITIF POUR DEPOSER DES MATERIAUX PRESENTANT UNE GRANDE BANDE INTERDITE ET UNE GRANDE ENERGIE DE LIAISON

(30) Priorität: 24.08.1999 DE 19940033
(43) Veröffentlichungstag der Anmeldung: 03.07.2002
(73) Patentinhaber: Aixtron AG, 52072 Aachen (DE)
(72) Erfinder: KAEPPELER, Johannes, 52146 Würselen (DE); WISCHMEYER, Frank, 52072 Aachen (DE); STRAUCH, Gert, 52072 Aachen (DE); JÜRGENSEN, Holger, 52072 Aachen (DE)
(74) Vertreter: Grundmann, Dirk, Dr.
(86) Internationale Anmeldenummer: PCT/DE2000/002890
(87) Internationale Veröffentlichungsnummer: WO 2001/014619

(56) Entgegenhaltungen:
- EP-A- 0 748 881
- WO-A-96/23914
- WO-A-97/31133
- WO-A-98/42897
- DE-A- 3 608 783
- DE-A- 19 522 574
- DE-A- 19 803 423
- US-A- 5 743 956
- US-A- 5 788 777
- PATENT ABSTRACTS OF JAPAN vol. 1995, no. 02, 31. März 1995 (1995-03-31) & JP 06 310440 A (FUJI ELECTRIC CO LTD), 4. November 1994 (1994-11-04)

## Beschreibung

### Technisches Gebiet

Die Erfindung bezieht sich auf ein verfahren und eine Vorrichtung zur Abscheidung von SiC- und/oder SiCₓ Ge₁₋ₓ (x=0-1) -Halbleiterschichten und verwandter Materialien mit großer elektronischer Bandlücke und großer Bindungsenergie, wie z.B. AIN und GaN, aus der Gasphase und insbesondere mittels eines CVD-Verfahrens.

### Stand der Technik

Die US 5,788,777 beschreibt einen Epitaxie-Reaktor mit einem rotierenden Suszeptor, auf dem planetenartig Substrathalterteller angeordnet sind. Der Substrathalter befindet sich in einer Prozesskammer, in welcher sich auch eine Heizung befindet, so dass der Substrathalter von unten beheizbar ist. Oberhalb des Substrathalters befindet sich eine Deckenplatte, die in ihrer Mitte einen Durchlass für einen Gaseinlas ausbildet, durch welchen Silan oder andere Ausgangsstoffe zum Abscheiden von Verbindungshalbleiterschichten in die Prozesskammer eingebracht werden kann.

Halbleiter mit großer Bandlücke eignen sich aufgrund ihrer physikalischen Eigenschaften besonders für Anwendungen jenseits des Einsatzbereiches von auf Si oder GaAs basierenden elektronischen Halbleiterbauelementen. Die Chemische Gasphasen Epitaxie (CVD) ist das geeignetste Verfahren, elektrisch aktive Schichten, wie SiC und/oder SiCₓ Ge₁₋ₓ (x=0-1), für elektronische Bauelemente für Hochtemperatur-, Hochfrequenz- und Hochleistungsanwednungen herzustellen.

Bei vertikalen, Raumladungszonen-gesteuerten Bauelementen, wie z.B. Schottky.-Dioden oder pn-Dioden, müssen für typische Leistungsanwendungen Sperrspannungen im Bereich U> 10 kV aufgenommen werden. Es ist deshalb erforderlich, dass die abgeschiedenen epitaktischen Schichten Dicken von bis zu 100µm aufweisen müssen.

Hohe Leistungen beinhaltet auch die Schaltbarkeit hoher Ströme I > 10 A. Nur großflächige Bauelemente können diese hohen Ströme im Durchlaßbereich führen. Die dadurch stetig steigende Forderung nach Substraten mit einem Mindestdurchmesser von 4" (Zoll) erfordert für die Epitaxie eine großflächige, homogene Aufheizbarkeit der Substrate.

Es werden herkömmlicherweise Heißwandreaktoren ohne rotierendem Substrat für das Abscheiden von SiC Schichten auf z.Z. 2" (Zoll) Substraten eingesetzt.

Diese haben den Nachteil, daß die Wachstumsrate über der Lauflänge des Gases stark abnimmt. Um diesen Effekt auszugleichen, variiert man nach dem Stand der Technik die Reaktorhöhe über der Lauflänge, um ein homogenes Wachstum auf dem Wafer zu ermöglichen.

Ein weiterer Nachteil ist das inhomogene Wachstum senkrecht zur Flußrichtung bedingt durch den Einfluß der Wände. An den Wänden findet Wachstum statt und dadurch werden zusätzliche Prozeßgase konsumiert. Weiterhin wirken die Wände sich nachteilig auf das Strömungsprofil im Reaktor aus. Hier ist nach dem Stand der Technik entweder durch die Variation des Prozeßdruckes und/oder des Flusses oder durch die Vergrößerung des Abstandes Wafer zur Wand eine Verbesserung möglich.

Ein weiterer Nachteil ist die Inhomogenität der Dotierung über der Lauflänge und senkrecht zur Lauflänge. In diesem Fall spielen vor allem Temperaturinhomogenitäten eine entscheidende Rolle, die im Falle eines Heißwandreaktors ohne Rotation nur durch großen apparativen Aufwand verbessert werden können.

Aus der EP-A-0 164 928 ist ein vertikaler Heißwandreaktor bekannt, bei dem die Substrate übereinander gestapelt sind. Dies erfordert einen mechanischen Antrieb.

Ein mechanischer Antrieb zur Rotation des oder der Substrate erfordert eine mechanische Durchführung zum heißen Substrathalter. Dies hat den Nachteil, daß die Durchführung zu einer Inhomogenität der Temperatur des Substrathalters führt, daß die mechanischen Elemente, wie z.B. Zahnräder, bei den benötigten Temperaturen von über 1400°C zu Abrieb führen und so einerseits Partikel generiert werden und anderseits Materialien freigesetzt werden, welche zu einer nicht erwünschten Hintergrunddotierung in den abgeschiedenen Schichten führen.

Ein weiterer Nachteil ist die auf dem Graphit des Substrathalters bzw. -trägers aufgebrachte Beschichtung zur gasdichten Versiegelung der Graphitoberfläche. Hier wird gemäß dem Stand der Technik SiC eingesetzt. Die Verwendung von SiC hat den Nachteil, daß die SiC-Beschichtung bei den für den Prozeß benötigten Temperaturen von über 1400°C von reaktiven Wasserstoffradikalen geätzt wird, und somit nur eine kurze Lebensdauer der Graphitteile gewährleistet ist. Weiterhin kann die Rückseite des Substrates durch "Close Space Epitaxy" ungewollt mit SiC von der beschichteten Graphitoberfläche beschichtet werden. Durch den Materialübertrag sind Löcher in der SiC Beschichtung die Folge. Zudem werden durch Poren und Löcher in der SiC-Beschichtung der Graphite Verunreinigungen frei, die sich als Fremdatome elektrisch aktiv in die Halbleiterschicht einbauen und die elektrischen Eigenschaften der Schicht beeinflussen können. Durch Poren und Löcher in der SiC-Beschichtung der Graphite werden bei den hohen Prozeßtemperaturen Kohlenwasserstoffe freigesetzt, die für die SiC Epitaxie den Anteil an Kohlenstoff in der Gasphase vergrößern und somit die Kontrollierbarkeit des Prozesses beeinträchtigen.

### Darstellung der Erfindung:

Der Erfindung liegt die Aufgabe zugrunde, ein Verfahren und ein Vorrichtung anzugeben, mit der unter anderem homo- oder heteroepitaktische SiC- und/oder SiCₓGe₁₋ₓ (x=0-1)- Schichten mit großen Wachstumsraten sehr homogen abgeschieden werden können.

Die Aufgabe wird durch ein Verfahren und eine Vorrichtung zur Abscheidung von SiC- und/oder SiCₓGe₁₋ₓ (x=0-1)-Halbleiterschichten und verwandter Materialien mit großer elektronischer Bandlücke und großer Bindungsenergie, wie z.B. AIN oder GaN, aus der Gasphase gelöst, wobei die Abscheidung in einem allseits beheizten Strömungskanalreaktor unter Verwendung eines rotierenden Substrates desselben Materials (Homoepitaxie) oder eines anderen geeigneten Materials (Heteroepitaxie), wie z.B. Silizium, Silicon on Insulator, Saphir, erfolgt.

Der Erfindung liegen ein entsprechendes Verfahren sowie eine entsprechende Vorrichtung zugrunde.

Die Erfindung zeichnet sich dadurch aus, daß in einem über dem Substrat geschlossenen, als allseits beheizten Strömungskanal ausgeführten Substrathalter bzw. -träger aus hochtemperaturbeständigen leitenden Material wie Graphit, ein oder mehrere Substrathalter bzw. -teller gedreht werden.

Eine andere Ausführungsform des beheizten Strömungskanals mit rotierenden Substraten ist die Anordnung als Radialflußreaktor. In dieser Ausführung lassen sich vorteilhaft mehrere Wafer gleichzeitig unter gleichen Prozeßbedingungen beschichten. In der als Radialflußreaktor ausgeführten Form strömen die Prozeßgase vom Zentrum durch den temperierten Gaseinlaß nach außen und über die rotierten Substrate in einen Abgassammler auf dem äußeren Umfang des Substrathalters bzw. -trägers. Der Radialflußreaktor besitzt vorteilhaft keine Wände, wodurch die beschriebenen negativen Seitenwandeffekte eines heißen Strömungskanal-Reaktors vermieden werden.

Die Drehung des oder der Substratteller kann vorteilhaft durch Gas-Foil-Rotation durchgeführt werden, wodurch mechanische Abriebe und aufwendige mechanische Lagerungen und Antriebe vermieden werden können.

Mit der Rotation des Substrates erreicht man vorteilhaft den Ausgleich der abnehmenden Wachstumsrate über der Lauflänge und senkrecht zur Lauflänge die Homogenisierung von eventuell vorhandenen Temperaturgradienten im Substrathalter bzw. Substratträger.

Durch die Rotation und insbesondere durch die Rotation mittels Gas-Foil-Rotation werden vorteilhaft ein homogenes Wachstum bzgl. Schichtdicke und Dotierung und eine homogene Temperaturverteilung erreicht. Darüber hinaus kann einerseits eine sehr geringe Partikelgenerierung durch die Verwendung der Gas-Foil-Rotation erreicht werden. Zudem spricht für die Gas-Foil-Rotation, daß das mechanische Drehen bei hohen Temperaturen ohne negative Einflüsse auf Temperaturhomogenität und Lebensdauer der Bauteile bisher nicht gelöste Probleme aufwirft.

Die dem Prozeßgas zugewandten Begrenzungswände insbesondere der Substrathalter und das/oder die rotierenden Substrate können mittels Hochfrequenzheizung, Lampenheizung, Widerstandsheizung oder einer beliebigen Kombination dieser Heizungen auf Temperaturen von bis zu 1800°C erhitzt werden. Dabei können vorteilhaft Temperatursteuerungs- und -regelungseinrichtungen verwendet werden, welche die Begrenzungen mit gleichen oder unterschiedlichen Temperaturen beheizen. Damit können die Prozeßbedingungen sehr spezifisch eingestellt bzw. variiert werden.

Zur Beheizung können insbesondere bei einer Hochfrequenzheizung eine oder mehrere Spulen um den bzw. über und unter dem Suszeptor bzw. Substrathalter angeordnet werden, um die Wärmeübertragung optimal und mit geringen Verlusten und Steuerungs- bzw. Regelungsproblemen zu ermöglichen.

Dabei ist auch eine getrennte Regelung der Temperatur von zwei bzw. jeweils zwei gegenüberliegenden Begrenzungswänden des beheizten Strömungskanals durch Einsatz von zwei getrennten Heizkreisen mit jeweils eigener Regelung möglich.

Insbesondere kann durch eine getrennte Regelung der Temperatur der substratseitigen Begrenzungswand von der gegenüberliegenden Begrenzungswand des beheizten Strömungskanals durch Einsatz von zwei getrennten Heizkreisen mit jeweils eigener Regelung vorteilhaft der Temperaturgradient senkrecht zum Substrat festgelegt werden. Damit wird vorteilhaft die Reduktion von Si-Clusterund -Keimbildung im Gasstrom erreicht.

Bei dem Einsatz zweier getrennt geregelter Heizkreise für jeweils die Temperatur der substratseitigen Begrenzungswand und der gegenüberliegenden Begrenzungswand können also die Temperaturen getrennt eingestellt werden. Dadurch lassen sich vorteilhaft konstante Temperaturgradienten zwischen Substrat und der gegenüberliegenden Begrenzungswand des Strömungskanals einstellen.

Die dem Prozessgas zugewandten Begrenzungswände des beheizten Strömungskanals und insbesondere der Substratträger bzw. Substrathalter und der/die Substratteller können insbesondere aus hochleitendem Material ausgeführt sein, um auch dadurch die Homogenität der erzeugten Materialien zu unterstützen bzw. zu verbessern.

Weiterhin werden vorteilhaft die dem Prozessgas zugewandten Begrenzungswände des beheizten Strömungskanals und insbesondere die Substratteller und Substrathalter mit einer durch Wasserstoffradikale nicht ätzbaren, bei Temperaturen bis 1800°C nicht sublimierenden, auf das Graphit der Substratteller bzw. Substrathalter aufgebrachten Beschichtung, z.B. TaC, so geschützt, daß auch bei hohen Temperaturen und langen Anwendungszeiten die Oberfläche der Beschichtung geschlossen bleibt. Durch die Vermeidung freier Graphitoberflächen wird somit vorteilhaft die Freisetzung von Verunreinigungen aus dem Graphit minimiert. Dadurch lassen sich ungewollte Hintergrunddotierungen auf < 5x 10¹⁴ cm⁻³ begrenzen. Durch die stabile, gasdichte Versiegelung wird die Bildung von zusätzlichen Kohlenwasserstoffen vorteilhaft unterdrückt. Die Kontrollierbarkeit der Zusammensetzung der Gasphase aus Silizium und Kohlenstoff in unmittelbarer Nähe zum Substrat wird somit erhöht.

Es wird vorteilhaft eine Close Space Epitaxy auf der Rückseite des Substrates durch die Verwendung von temperaturbeständigen und gegen Wasserstoffradikalen ätzbeständigen Beschichtungen vermieden. Solche Beschichtungen für den Substratteller aus Graphit können insbesondere aus z.B. TaC bestehen.

Die in den als Strömungskanal ausgeführten Substrathalter bzw. -träger eintretenden Gase werden bis kurz vor Eintritt durch einen aktiv gekühlten Einlaß weit unter Zerlegungstemperatur der Prozeßgase gehalten. Somit wird vorteilhaft die Zerlegung der Prozeßgase so weit wie möglich bis kurz vor dem Substrat verhindert. Eine Abscheidung aus der Gasphase kann somit erst über dem Substrat erfolgen.

Der gekühlte Einlaß und der heiße Substrathalter bzw. - träger werden bevorzugt nur durch ein schmales, stark wärmeisolierendes Segment thermisch getrennt und gegenseitig verbunden. Dies ist eine vorteilhafte - da einfache - Wärmeisolierung.

Diese beiden vorhergehenden Merkmale ermöglichen somit eine hohe Effizienz der abzuscheidenden Prozeßgase, da diese erst kurz vor dem Substrat zerlegt werden. Durch den abrupten Temperaturübergang wird zusätzlich eine preferentielle Verarmung einer Gasspezies in einem Temperaturbereich unterdrückt, was der Kontrollierbarkeit der Komposition der Gasphase in unmittelbarer Nähe zum Substrat dient.

Durch den geringen Temperaturgradienten senkrecht zum Substrathalter bzw. -träger im heißen Strömungskanal erreicht man eine effektive Zerlegung der Quellengase. Der abrupte Temperaturübergang zwischen Gaseinlaß und Substrathalter bzw. -träger und der geringe Temperaturgradient senkrecht zum Substrathalter bzw. -träger reduziert die Wahrscheinlichkeit der Bildung von Si-Clustern oder Keimbildung in dem Gasstrom. Dadurch erreicht man vorteilhaft eine Maximierung der Wachstumsrate.

In einem solchem Strömungskanal mit integriertem Substrathalter bzw. -träger erreicht man dadurch Wachstumsraten >10µm/h.

Durch die Ausgestaltung des Strömungskanals hinter dem Substrathalter bzw. -träger mit Auslaßsegmenten aus verschiedenen inerten Materialien werden Reaktionen der ausströmenden Gase vermieden und somit weiterhin die Homogenität der zu erzeugenden Materialien verbessert. Die Prozeßbedingung sind somit reproduzierbar. Unkontrollierbare Einflüsse durch Reaktionen der ausströmenden Gase werden vermieden.

Das Einbringen von dünnen Körpern aus inerten Materialien mit anderen Leitfähigkeiten (z.B. Ta, Mo) als der Substrathalter auf oder in dem Substrathalter dient vorteilhaft der Beeinflussung der Temperaturverteilung in diesem, unabhängig von der Spulenposition.

Bei der anderen Ausführungsform des beheizten Strömungskanals mit rotierenden Substraten als die Anordnung als Radialflußreaktor ist es zudem vorteilhaft, daß die dem Substrat gegenüberliegende Begrenzungswand des beheizten Strömungskanals in einem bestimmten Abstand zur substratseitigen Begrenzung des beheizten Strömungskanals mit dieser drehbar verbunden ist. Dadurch erfolgt eine verbesserte Rotationsbewegung des mindestens einen Substrats innerhalb des Strömungskanals zur Erreichung einer optimalen Homogenität der erzeugten Halbleiterschichten.

Weiterhin ist es vorteilhaft, daß die dem Substrat gegenüberliegende Begrenzungswand des beheizten Strömungskanals zur Bereitstellung des erwünschten Temperatürgradienten durch ein gasförmiges Medium aktiv kühlbar ist. Damit können die Temperaturgradienten und die Temperaturzeitverläufe vorteilhaft beeinflußt werden.

Da das rotierende Substrat durch einen an einer beliebigen Begrenzungswand des beheizten Strömungskanals angeordneten Substrathalter positionierbar ist, können vorteilhaft Schwerkrafteffekte gezielt zur Prozeßoptimierung genutzt werden.

Ist der Gasausgang des Substrathalters als Gasverteilerring ausgeführt, können die Gase gleichförmig auf dem Umfang aus dem Strömungskanal abgeleitet werden. Die Ausführung des Gasverteilerringes aus verschiedenen inerten Materialien führt zu einer vorteilhaften Beeinflußung der Temperaturgradienten und Temperaturzeitverläufen. Auch hier wird die Anzahl der beeinflußbaren Prozeßparameter in vorteilhafter Weise erhöht. Reaktionen der austretenden Gase werden damit vermieden.

Das entsprechende erfindungsgemäße Verfahren kann vorteilhaft durch Verwendung entsprechender Prozeß- und Trägergase, durch eine optimale Temperaturführung in Verbindung mit entsprechenden Drücken so ausgeführt werden, daß Schichten mit großen Wachstumsraten sehr homogen abgeschieden werden. Dabei sollen insbesondere bereits bekannte Abscheidungsverfahren wie CVD-, MOCVD oder MOVPE-Verfahren verbessert werden.

Durch das Einleiten von weit unter Prozeßtemperatur gekühltem Prozeß- und Trägergas kurz vor dem heißen Substrat wird eine vorzeitigen Zerlegung von Quellengasen und die lokale Übersättigung des Gasstromes mit einem Zerlegungsprodukt vermieden.

Bei dem erfindungsgemäßen Verfahren kommen ausgewählte Prozeß- und Trägergase zur Anwendung, welche die Qualität der erzeugten Halbleiterschichten vorteilhaft beeinflussen.

Es werden insbesondere Dotierungen von 5x10¹⁴ cm ⁻³ bis 1x10¹⁹ cm⁻³ erreicht.

Durch die vollständige Zerlegung von Quellengasen vor oder über dem Substrat werden vorteilhaft, bedingt durch das homogene Temperaturprofil des Substrathalters, auch Wachstumsraten für SiC- und/oder SiCₓGe₁₋ₓ (x=0-1)- Halbleiterschichten von 10 µm/h oder mehr erreicht.

Mit bei dem erfindungsgemäßen Verfahren erzeugten geringen Temperaturgradienten senkrecht zum Substrat werden vorteilhaft die Reduktion von Si-Cluster- und - Keimbildung im Gasstrom erreicht.

Es ist vorteilhaft homo- oder heteroepitaktisches Abscheiden möglich.

### Kurze Beschreibung der Zeichnung

Die Erfindung wird nachstehend ohne Beschränkung des allgemeinen Erfindungsgedankens anhand von Ausführungsbeispielen unter Bezugnahme auf die Zeichnung exemplarisch beschrieben, auf die im übrigen hinsichtlich der Offenbarung aller im Text nicht näher erläuterten erfindungsgemäßen Einzelheiten ausdrücklich verwiesen wird. Es zeigen:
- Fig. 1:: eine Darstellung einer erfindungsgemäßen Vorrichtung zum Abscheiden von Schichten aus der Gasphase im Querschnitt,
- Fig. 2:: eine Darstellung des Temperaturverlaufs in Abhängigkeit von dem Ort innerhalb der Vorrichtung gemäß Fig. 1,
- Fig. 3:: eine Darstellung einer weiteren erfindungsgemäßen Vorrichtung in der Ausführung als Radialflußreaktor mit Doppelrotation zum Abscheiden von Schichten aus der Gasphase im Querschnitt,
- Fig. 4:: eine Darstellung des Temperaturverlaufs in Abhängigkeit von dem Ort innerhalb der Vorrichtung gemäß Fig. 3.

### Beschreibung von Ausführungsbeispielen

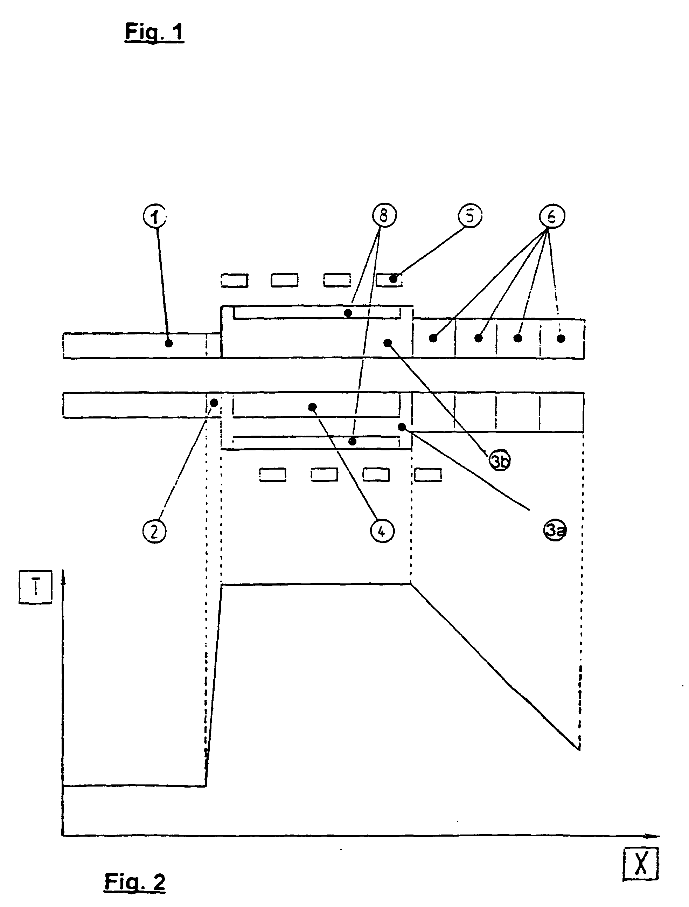

Bei dem Ausführungsbeispiel gemäß Fig. 1 bezeichnen die Bezugszeichen folgende Elemente3 eines erfindungsgemäßen Systems bzw. einer erfindungsgemäßen Vorrichtung:

Das Bezugszeichen 1 bezeichnet einen aktiv gekühlten Einlaß. Das Bezugszeichen 2 bezeichnet ein kurzes Isolationssegment aus hochisolierendem temperaturfesten Material (z.B. Graphitschaum) zwischen kaltem Einlaß 1 und dem beheizten Strömungskanal.

Das Bezugszeichen 3a bezeichnet einen Substrathalter bzw. Substratträger mit einem durch Gas-Foil-Rotation rotierenden Substratteller 4, wobei beide aus hochtemperaturbeständigen und leitenden Material (z.B. Graphit) mit einer inerten und auch bei Temperaturen bis 1800°C gegen Wasserstoffradiakale resistenten Beschichtung (z.B. TaC) bestehen. Dem Substrathalter 3a gegenüber liegt eine obere Begrenzung 3b des Strömungskanals zur mit (nicht gezeigten) Seitenwänden erfolgenden Ausbildung eines senkrecht zur Gasflußrichtung geschlossenen Strömungskanals, in dem der Substrathalter 3a integriert ist. Dabei kann der Substrathalter 3a auch an anderen Begrenzungswänden angeordnet werden. Das Bezugszeichen 5 bezeichnet eine oder mehrere Spulen, welche um oder über und unter dem geschlossenen Substrathalter 3a angeordnet sind, um den kompletten Strömungskanal aktiv zu erhitzen. Das Bezugszeichen 6 bezeichnet ein oder mehrere Auslaßsegmente aus verschiedenen Materialien, um die Temperatur zwischen Suszeptor und Gasauslaß kontinuierlich abzusenken. Das Bezugszeichen 8 bezeichnet im Verhältnis zum Substrathalter 3a dünne Platten aus Materialien, welche eine andere elektrische Leitfähigkeit als der Substrathalter 3a haben und inert sind (z.B. Mo, Te), um die Temperaturverteilung unabhängig von der Spulenposition zu beeinflussen.

Fig. 2 zeigt den Temperaturverlauf innerhalb des Systems in Abhängigkeit vom Ort der Prozeßgase in dem System. Dabei ist ersichtlich, daß die Prozeßgase bis zum Einlaß in den erhitzen Strömungskanal gekühlt geführt werden, um dann sehr schnell auf Temperaturen gebracht zu werden, die für eine Pyrolyse der Prozeßgase erforderlich sind. Nach dem Auslaß erfolgt durch die Auslaßsegmente eine kontinuierliche und kontrollierte Abkühlung der Prozeßgase.

Fig. 3 zeigt ein weiteres Ausführungsbeispiel für ein erfindungsgemäßes System bzw. eine erfindungsgemäße Vorrichtung, die als Radialflußreaktor mit Doppelrotation ausgebildet ist. Der Reaktor ist zur der strichpunktierten Linie links in Fig. 3 symmetrisch ausgebildet, so daß lediglich eine Hälfte dargestellt ist. Auch hier bezeichnet Bezugszeichen 1 einen aktiv gekühlten Einlaß. Das Bezugszeichen 2 bezeichnet ein kurzes Isolationssegment aus hochisolierendem temperaturfesten Material (z.B. Graphitschaum) zwischen kaltem Einlaß 1 und heißem Suszeptor. Das Bezugszeichen 3a bezeichnet einen Substrathalter bzw. Substratträger mit einem durch Gas-Foil-Rotation rotierenden Substratteller 4, wobei beide aus hochtemperaturbeständigen und leitenden Material (z.B. Graphit) mit einer inerten und auch bei Temperaturen bis 1800°C gegen Wasserstoffradiakale resistenten Beschichtung (z.B. TaC) bestehen. Dem Substrathalter 3a gegenüber liegt eine Begrenzung 3b zur mit (nicht gezeigten) Seitenwänden erfolgenden Ausbildung eines senkrecht zur Gasflußrichtung geschlossenen Strömungskanals, in dem der Substrathalter 3a integriert ist. Dabei kann der Substrathalter 3a auch an anderen Begrenzungswänden angeordnet werden. Das Bezugszeichen 5 bezeichnet eine oder mehrere Spulen, welche um oder über und unter dem geschlossenen Substrathalter 3a angeordnet sind, um den kompletten Substrathalter 3a aktiv zu erhitzen. Das Bezugszeichen 6 bezeichnet ein oder mehrere Auslaßsegmente aus verschiedenen Materialien, um die Temperatur zwischen Suszeptor und Gasauslaß kontinuierlich abzusenken. Das Bezugszeichen 8 bezeichnet im Verhältnis zum Substrathalter bzw. Substratträger 3a dünne Platten aus Materialien, welche eine andere elektrische Leitfähigkeit als der Substrathalter 3a haben und inert sind (z.B. Mo, Ta), um die Temperaturverteilung unabhängig von der Spulenposition zu beeinflussen.

Im Unterschied zum System nach Fig. 1 bezeichnet das Bezugszeichen 7 zusätzlich in der Ausführung als Radialflußreaktor mit Doppelrotation einen Auslaßring, der für eine gleichmäßige Flußaufteilung über den Umfang des Substrathalters sorgt.

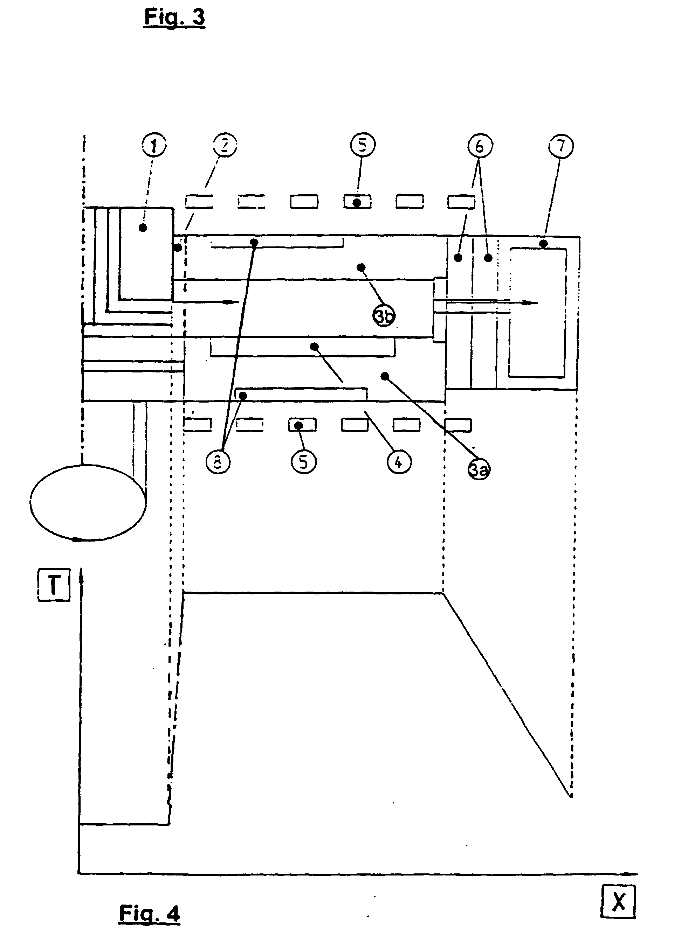

Fig. 4 zeigt den Temperaturverlauf für das System in der Ausführung als Radialflußreaktor mit Doppelrotation; dieser Temperaturveraluf entspricht im Prinzip dem Temperaturverlauf nach Fig. 2.

## Patentansprüche

1. Verfahren zum Abscheiden von Halbleiterschichten aus SiC- und/oder SiCₓGe₁₋ₓ (X=0 -1), AlN, GaN oder verwandter Materialien mittels eines CVD-Verfahrens, wobei
- wenigstens ein Substrat auf eine Temperatur von ca. 1100°C bis ca. 1800°C erwärmt wird;
- das wenigstens eine Substrat in einem aktiv beheizten Strömungskanalreaktor rotiert;
- die Beschichtung homo- oder heteroepitaktisch erfolgt;
- ein oder mehrere Prozess- oder Trägergase kurz vor dem heißen Substrat eingeleitet werden;
**dadurch gekennzeichnet,**
- **dass** der Strömungskanalreaktor allseitig beheizt ist und
- **dass** die Prozess- oder Trägergase vor dem Einleiten auf eine Temperatur, die weit unter der Prozesstemperatur liegt, aktiv gekühlt werden, so dass die vorzeitige Zerlegung von Prozessgasen und/oder eine lokale Übersättigung des Gasstromes mit einem Zerlegungsprodukt vermieden wird.

2. Verfahren nach Anspruch 1,
**dadurch gekennzeichnet, dass** die Substrate auf wenigstens einem in oder auf einem Substrathalter angeordneten Substrahalterteller angeordnet sind, und dass der oder die Substratteller durch "Gas-Foil-Rotation" relativ zu dem Substrathalter angetrieben werden.

3. Verfahren nach einem der Ansprüche 1 oder 2,
**gekennzeichnet durch** die Verwendung von Silan (SiH₄) oder anderer Sihaltiger anorganischer und organischer Ausgangsmaterialien, German (GeH₄) und Propan (C₃H₈) oder anderer Kohlenwasserstoffgase als Pro zessgase.

4. Verfahren nach einem der Ansprüche 1 bis 3,
**dadurch gekennzeichnet, dass** durch die vollständige Zerlegung von Quellengasen vor oder über dem Substrat, bedingt durch das homogene Temperaturprofil des Substrathalters, so dass Wachtumsraten für SiCund/ oder SiCₓ Ge₁₋ₓ (x=0-1)-Halbleiterschichten von 2µm/h und mehr erreicht werden.

5. Verfahren nach einem der Ansprüche 1 bis 4,
**dadurch gekennzeichnet, dass** durch geringe Temperaturgradienten senkrecht zum Substrat die Reduktion von Si-Cluster- und -Keimbildung im Gasstrom erreicht wird.

6. Verfahren nach einem der Ansprüche 1 bis 5,
**dadurch gekennzeichnet, dass** die Schichten bei Prozessdrücken zwischen 10-1000 mbar abgeschieden werden.

7. Vorrichtung zur Herstellung von SiC-Halbleiterschichten und verwandter Materialien mit großer elektronischer Bandlücke und hoher Bindungsenergie mittels eines Gasphase-Aufbringverfahrens und insbesondere eines CVD-Verfahrens, mit
- einer Reaktorkammer, die wenigstens einen Gaseinlass für die Reaktorgase aufweist;
- einem drehbaren Substrathalter, auf dem das oder die Substrate horizontal (nebeneinander) angeordnet sind;
- wobei der Gaseinlass kurz vor dem Substrathalter angeordnet ist;
- einem Gasauslass und
- einer Heizeinrichtung, die den Substrathalter und somit die zu beschichtenden Substrathalteroberflächen gesteuert auf Temperaturen von 1100°C bis 1800°C erwärmt;
**dadurch gekennzeichnet,**
- **dass** auch der den zu beschichtenden Substratoberflächen gegenüberliegende Wandbereich der Reaktorkammer aktiv auf hohe Temperaturen erwärmbar ist und
- dem Gaseinlass eine Kühleinrichtung zugeordnet ist, um die Prozessgase auf eine Temperatur zu kühlen, die weit unter der Prozesstemperatur liegt.

8. Vorrichtung nach Anspruch 7,
**dadurch gekennzeichnet, dass** die Reaktorkammer rotationssymmetrisch aufgebaut ist und einen zentralen Gaseinlass und einen rotationssymmetrischen Gasauslass aufweist.

9. Vorrichtung nach Anspruch 7 oder 8,
**dadurch gekennzeichnet, dass** die dem Reaktorraum zugewandten Begrenzungswände der Reaktorkammer und der oder die Substratteller bzw. Substrathalter eine geschlossene inerte und bis 1800°C hochtemperaturbeständige sowie durch Wasserstoffradikale nicht ätzbare Beschichtung insbesondere aus TaC, NbC, etc. aufweisen.

10. Vorrichtung nach einem der Ansprüche 7 bis 9,
**gekennzeichnet durch** eine Dreheinrichtung zur Rotation des mindestens einen Substrats jeweils auf einem in oder auf einem Substrathalter angeordneten Substratteller mittels "Gas-Foil-Rotation".

11. Vorrichtung nach einem der Ansprüche 7 bis 10,
**gekennzeichnet durch** eine Dreheinrichtung zur Rotation des mindestens einen Substrats jeweils auf einem in oder auf einem Substrathalter angeordneten Substratteller mittels einer mechanisch angetriebenen Achse.

12. Vorrichtung nach einem der Ansprüche 7 bis 11,
**gekennzeichnet durch** mindestens eine Temperatursteuer- bzw. Regelungseinrichtung zur Bereitstellung einer gleichen oder unterschiedlichen Temperatur aller dem Prozessgas zugewandten Begrenzungswände als Oberseite, Unterseite und Seitenwände des damit geschlossenen beheizten Strömungskanals.

13. Vorrichtung nach einem der Ansprüche 7 bis 12,
**dadurch gekennzeichnet, dass** zur Beheizung der dem Prozessgas zugewandten Begrenzungswände und insbesondere des Substrathalters eine beliebige Kombination aus Hochfrequenz-, Lampen- und Widerstandsheizungen vorgesehen sind.

14. Vorrichtung nach einem der Ansprüche 7 bis 13,
**dadurch gekennzeichnet, dass** eine getrennte Regelung der Temperatur der substratseitigen Begrenzungswand von der gegenüberliegenden Begrenzungswand des beheizten Strömungskanals durch Einsatz von zwei getrennten Heizkreisen mit jeweils eigener Regelung erfolgt.

15. Vorrichtung nach einem der Ansprüche 7 bis 14,
**dadurch gekennzeichnet, dass** die dem Prozessgas zugewandten Begrenzungswände des beheizten Strömungskanals und insbesondere der oder die Substratteller bzw. der Substrathalter, aus einem hochleitenden Material wie Graphit ausgeführt sind.

16. Vorrichtung nach einem der Ansprüche 7 bis 15,
**dadurch gekennzeichnet, dass** die dem Prozessgas zugewandten Begrenzungswände des beheizten Strömungskanals und insbesondere der oder die Substratteller bzw. der Substrathalter eine geschlossene, inerte, hochtemperaturbeständige (bis ca. 1800°C) und durch Wasserstoffradikale nicht ätzbare Beschichtung aus z.B. TaC, NbC etc. aufweist.

17. Vorrichtung nach einem der Ansprüche 7 bis 16,
**dadurch gekennzeichnet, dass** eine Kühleinrichtung den Gaseinlass bis kurz vor dem erhitzten Strömungskanal mit einem flüssigen oder gasförmigen Medium aktiv kühlt.

18. Vorrichtung nach einem der Ansprüche 7 bis 17,
**dadurch gekennzeichnet, dass** der kühle Gaseinlass durch ein hochisolierendes schmales Adapterstück zum allseits beheizten Strömungskanal hin abdichtet.

19. Vorrichtung nach einem der Ansprüche 7 bis 18,
**dadurch gekennzeichnet, dass** der Strömungskanal hinter der aktiv beheizten Zone aus Auslasssegmenten besteht, die verschiedene inerte Materialien (z.B. TaC beschichtetes Graphit, SiC beschichtetes Graphit, Quarz etc.) aufweisen.

20. Vorrichtung nach einem der Ansprüche 7 bis 19,
**dadurch gekennzeichnet, dass** im Verhältnis zur Dicke des Substrathalters dünne Platten aus inerten Materialien (z.B. Ta, Mo, W) mit unterschiedlicher elektrischer Leitfähigkeit als der Substrathalter, auf oder in dem Substrathalter eingelegt werden können, um die Hochfrequenzeinkopplung und damit den Energieeintrag lokal zu beeinflussen.

21. Vorrichtung nach einem der Ansprüche 15 bis 20,
**dadurch gekennzeichnet, dass** die dem Substrat gegenüberliegende Begrenzungswand des beheizten Strömungskanals in einem bestimmten Abstand zur substratseitigen Begrenzung des beheizten Strömungskanals fest installiert ist oder mit dieser drehbar verbunden ist.

22. Vorrichtung nach einem der Ansprüche 7 bis 21,
**dadurch gekennzeichnet, dass** die dem Substrat gegenüberliegende Begrenzungswand des beheizten Strömungskanals durch ein gasförmiges Medium aktiv kühlbar ist.

## Claims

1. A method for the deposition of semiconductor layers comprising SiC and/or SiCₓGe₁₋ₓ(X=0 - 1), AlN, GaN or related materials by means of a CVD method, in which
- at least one substrate is heated to a temperature of approx. 1100°C to approx. 1800°C;
- the at least one substrate rotates in an actively heated flow channel reactor;
- the coating takes place homoepitaxially or heteroepitaxially;
- one or more process or carrier gases are introduced just ahead of the hot substrate;
**characterized**
- **in that** the flow channel reactor is heated on all sides, and
- **in that** the process or carrier gases, before being introduced, are actively cooled to a temperature which is well below the process temperature, so that premature decomposition of process gases and/or local supersaturation of the gas stream with a decomposition product is avoided.

2. The method according to claim 1, **characterized in that** the substrates are disposed on at least one substrate holder plate, which is disposed in or on a substrate holder, and **in that** the substrate plate(s) are driven relative to the substrate holder by "gas foil rotation".

3. The method according to one of claims 1 or 2, **characterized by** the use of silane (SiH₄) or other Si-containing inorganic and organic starting materials, germane (GeH₄) and propane (C₃H₈) or other hydrocarbon gases as process gases.

4. The method according to one of claims 1 to 3, **characterized in that** by the complete decomposition of source gases ahead of or above the substrate, on account of the homogeneous temperature profile of the substrate holder, so that growth rates of 10 µm/h or more are achieved for SiC and/or SiCₓGe₁₋ₓ (x=0-1) semiconductor layers.

5. The method according to one of claims 1 to 4, **characterized in that** the reduction of Si cluster and seed formation in the gas stream is achieved by low temperature gradients perpendicular to the substrate.

6. The method according to one of claims 1 to 5, **characterized in that** the layers are deposited at process pressures of between 10-1000 mbar.

7. A device for producing Si-C semiconductor layers and related materials with a wide electronic band gap and a high binding energy by means of a vapor-phase application method, and in particular a CVD method, having:
- a reactor chamber, which. has at least one gas inlet for the reaction gases;
- a rotatable substrate holder, on which the substrate(s) are disposed horizontally (next to one another);
- the gas inlet being disposed just ahead of the substrate holder;
- a gas outlet, and
- a heater device, which heats the substrate holder and therefore the substrate holder surfaces which are to be coated, in a controlled manner, to temperatures of from 1100°C to 1800°C;
**characterized**
- **in that** the wall region of the reactor chamber which lies opposite the substrate surfaces which are to be coated can also be actively heated to high temperatures, and
- a cooling device is associated with the gas inlet in order to cool the process gas to a temperature which is well below the process temperature.

8. The device according to claim 7, **characterized in that** the reactor chamber is constructed in rotationally symmetrical form and has a central gas inlet and a rotationally symmetrical gas outlet.

9. The device according to claim 7 or 8, **characterized in that** the boundary walls of the reactor chamber, which face the reactor space, and the substrate plate(s) and/or substrate holder(s) have a continuous, inert coating, in particular comprising TaC, NbC, etc., which is able to withstand high temperatures of up to 1800°C and cannot be etched by hydrogen radicals.

10. The device according to one of claims 7 to 9, **characterized by** a turning device for rotation of the at least one substrate in each case on a substrate plate which is disposed in or on a substrate holder, by means of "gas foil rotation".

11. The device according to one of claims 7 to 10, **characterized by** a turning device for rotation of the at least one substrate in each case on a substrate plate, which is disposed in or on a substrate holder, by means of a mechanically driven shaft.

12. The device according to one of claims 7 to 11, **characterized by** at least one temperature control device for providing a uniform or different temperature to all the boundary walls facing the process gas, as top side, underside and side walls of the heated flow channel which is thereby closed off.

13. The device according to one of claims 7 to 12, **characterized in that** any desired combination of high-frequency, lamp and resistance heating means are provided for the purpose of heating the boundary walls which face the process gas, and in particular the substrate holder.

14. The device according to one of claims 7 to 13, **characterized in that** separate control of the temperature of the substrate-side boundary wall from the opposite boundary wall of the heated flow channel is effected by using two separate heating circuits, each with a dedicated control means.

15. The device according to one of claims 7 to 14, **characterized in that** the boundary walls, which face the process gas, of the heated flow channel, and in particular the substrate plate(s) and/or the substrate holder, are made from a highly conductive material, such as graphite.

16. The device according to one of claims 7 to 15, **characterized in that** the boundary walls, which face the process gas, of the heated flow channel, and in particular the substrate plate(s) and/or the substrate holder, has a continuous, inert coating of, for example, TaC, NbC, etc., which is able to withstand high temperatures (up to approx. 1800°C) and cannot be etched by hydrogen radicals.

17. The device according to one of claims 7 to 16, **characterized in that** a cooling device actively cools the gas inlet, up to just before the heated flow channel, with a liquid or gaseous medium.

18. The device according to one of claims 7 to 17, **characterized in that** the cool gas inlet is sealed with respect to the flow channel which is heated on all sides by means of a highly insulating, narrow adapter piece.

19. The device according to one of claims 7 to 18, **characterized in that** the flow channel, downstream of the actively heated zone, comprises outlet segments which have different inert materials (e.g. TaC-coated graphite, SiC-coated graphite, quartz, etc.).

20. The device according to one of claims 7 to 19, **characterized in that** thin plates, compared to the thickness of the substrate holder, of inert materials (e.g. Ta, Mo, W) with a different electrical conductivity from the substrate holder can be fitted on or in the substrate holder, in order to locally influence the introduction of high frequency and therefore the input of energy.

21. The device according to one of claims 15 to 20, **characterized in that** the boundary wall, which lies opposite the substrate, of the heated flow channel is installed in a fixed position, at a defined distance from the substrate-side boundary of the heated flow channel, or is rotatably connected thereto.

22. The device according to one of claims 7 to 21, **characterized in that** the boundary wall, which lies opposite the substrate, of the heated flow channel can be actively cooled by a gaseous medium.

## Revendications

1. Procédé de dépôt de couches de semi-conducteurs constituées de SiC et/ou SiCₓGe₁₋ₓ (x =0-1), AIN, GaN ou matériaux apparentés au moyen d'un procédé CVD, dans lequel
- au moins un substrat est chauffé à une température d'environ 1100°C jusqu'à 1800°C environ ;
- le au moins un substrat tourne dans un réacteur à canal d'écoulement activement chauffé ;
- le dépôt se fait par homo- ou hétéroépitaxie
- un ou plusieurs gaz de procédé ou gaz supports sont introduits juste devant le substrat chaud ;
**caractérisé en ce que**,
- le réacteur à canal d'écoulement est chauffé de tous côtés et
- les gaz de procédé ou gaz supports sont refroidis activement avant l'introduction à une température qui se situe bien en deçà de la température de procédé, si bien que la décomposition prématurée des gaz de procédé et/ou une sursaturation locale du courant de gaz avec un produit de décomposition est évitée.

2. Procédé selon la revendication 1, **caractérisé en ce que** les substrats sont disposés sur au moins un plateau de console du substrat, disposé dans ou sur une console de substrat, et que le ou les plateaux de substrat sont entraînés relativement par rapport à la console du substrat par "gas-foil-rotation".

3. Procédé selon l'une des revendications 1 ou 2, **caractérisé par** l'utilisation de silane (SiH₄) ou autres matériaux de départ inorganiques ou organiques contenant du Si, de germane (GeH₄) et de propane (C₃H₈) ou autres gaz d'hydrocarbures à titre de gaz de procédé.

4. Procédé selon l'une quelconque des revendications 1 à 3, **caractérisé en ce que**, grâce à la décomposition complète des gaz sources devant ou au-dessus du substrat, conditionnée par le profil de température homogène de la console du substrat, on obtient des taux de croissance pour les couches de semi-conducteurs de SiC et/ou SiCₓGe₁₋ₓ (x =0-1) de 10 *µ*m/h et plus.

5. Procédé selon l'une des revendications 1 à 4, **caractérisé en ce que**, grâce à de faibles gradients de températures perpendiculairement au substrat, on obtient la réduction des clusters de Si et de la formation de germes de Si dans le courant de gaz.

6. Procédé selon l'une des revendications 1 à 5, **Caractérisé en ce que** les couches sont déposées à des pressions de procédé situées entre 10 et 1000 mbars.

7. Dispositif pour la fabrication de couches de semi-conducteurs en SiC et de matériaux apparentés avec une grande bande interdite électronique et une grande énergie de liaison au moyen d'un procédé de dépôt en phase gazeuse et en particulier d'un procédé CVD, ayant :
- une chambre de réacteur, qui présente au moins une entrée de gaz pour les gaz du réacteur ;
- une console de substrat rotative, sur laquelle le ou les substrats sont disposés à l'horizontal (les uns à côté des autres) ;
- où l'entrée de gaz est disposée juste devant la console du substrat ;
- une sortie de gaz et
- un système de chauffage qui chauffe la console du substrat et ainsi les surfaces de la console du substrat à recouvrir de manière contrôlée à des températures allant de 1100°C à 1800°C ;
**caractérisé en ce que**
- la zone de la paroi de la chambre du réacteur, située à l'opposé des surfaces du substrat à recouvrir, peut être activement chauffée à des températures élevées et
- un système de refroidissement est affecté à l'entrée de gaz pour refroidir les gaz de procédé à une température qui se situe bien en deçà de la température de procédé.

8. Dispositif selon la revendication 7, **caractérisé en ce que** la chambre du réacteur est construite par symétrie de rotation et qu'elle comporte une entrée de gaz centrale et une sortie de gaz présentant une symétrie de rotation.

9. Dispositif selon la revendication 7 ou 8, **caractérisé en ce que** les parois de délimitation de la chambre du réacteur, tournées vers l'espace du réacteur, et le ou les plateaux de substrat ou consoles de substrat présentent un revêtement clos inerte, résistant à de hautes températures allant jusqu'à 1800°C et non attaquable par des radicaux d'hydrogène, en particulier constitué de TaC, NbC, etc.

10. Dispositif selon l'une des revendications 7 à 9, **caractérisé par** un système de rotation pour la rotation du au moins un substrat respectivement sur un plateau de substrat disposé dans ou sur une console de substrat au moyen de la "gaz-foil-rotation".

11. Dispositif selon l'une des revendications 7 à 10, **caractérisé par** un système de rotation pour la rotation du au moins un substrat respectivement sur un plateau de substrat disposé dans ou sur une console de substrat au moyen d'un axe entraîné mécaniquement.

12. Dispositif selon l'une des revendications 7 à 11, **caractérisé par** au moins un système de commande ou de réglage de la température pour l'instauration d'une température identique ou différente sur toutes les parois de délimitation, tournées vers le gaz de procédé, en tant que face supérieure, face inférieure et parois latérales du canal d'écoulement chauffé ainsi fermé.

13. Dispositif selon l'une des revendications 7 à 12, **caractérisé en ce que**, pour le chauffage des parois de délimitation tournées vers le gaz de procédé et en particulier de la console du substrat, une combinaison quelconque de chauffages par haute fréquence, ampoule et résistance, est prévue.

14. Dispositif selon l'une des revendications 7 à 13, **caractérisé en ce qu'**un réglage séparé de la température de la paroi de délimitation du côté substrat et de la paroi de délimitation opposée du canal d'écoulement chauffé se fait par utilisation de deux circuits de chauffage séparés.

15. Dispositif selon l'une des revendications 7 à 14, **caractérisé en ce que** les parois de délimitation du canal d'écoulement chauffé, tournées vers le gaz de procédé, et en particulier le ou les plateaux du substrat ou bien la console du substrat sont réalisés en un matériau hautement conducteur comme le graphite.

16. Dispositif selon l'une des revendications 7 à 15, **caractérisé en ce que** les parois de délimitation du canal d'écoulement chauffé, tournées vers le gaz de procédé, et en particulier le ou les plateaux de substrat ou bien la console du substrat présentent un revêtement clos, inerte, résistant à de hautes températures (jusqu'à environ 1800°C) et qui n'est pas attaquable par les radicaux d'hydrogène, constitué par exemple de TaC, NbC, etc.

17. Dispositif selon une des revendications 7 à 16, **caractérisé en ce qu'**un système de refroidissement refroidit activement l'entrée de gaz, jusqu'à un niveau situé juste devant le canal d'écoulement chauffé, avec un milieu liquide ou gazeux.

18. Dispositif selon une des revendications 7 à 17, **caractérisé en ce que** l'entrée de gaz refroidie est étanche vis à vis du canal d'écoulement chauffé de tous côtés grâce à une pièce d'adaptateur étroite hautement isolante.

19. Dispositif selon une des revendications 7 à 18, **caractérisé en ce que** le canal d'écoulement derrière la zone activement chauffée se compose de segments d'évacuation, présentant des matériaux inertes différents (par exemple graphite revêtu de TaC, graphite revêtu de SiC, quartz, etc.).

20. Dispositif selon une des revendications 7 à 19, **caractérisé en ce que** des plaques minces par rapport à l'épaisseur de la console du substrat, constituées de matériaux inertes (par exemple Ta, Mo, W) ayant des conductivités électriques différentes de celle de la console de substrat, peuvent être insérées sur ou dans la console du substrat pour influencer localement l'accouplement de haute fréquence et donc l'apport d'énergie.

21. Dispositif selon une des revendications 15 à 20, **caractérisé en ce que** la paroi de délimitation du canal d'écoulement chauffé, opposée au substrat, est solidement installée à une certaine distance par rapport à la délimitation du canal d'écoulement chauffé du côté substrat ou est reliée de manière rotative à celui-ci.

22. Dispositif selon une des revendications 7 à 21, **caractérisé en ce que** la paroi de délimitation du canal d'écoulement chauffé, opposée au substrat, peut être refroidie activement par un milieu gazeux.
